# EUROPEAN PATENT SPECIFICATION

(11) **EP 2 874 481 B1**
(45) Date of publication and mention of the grant of the patent: **25.01.2023**
(21) Application number: 12881079.3
(22) Date of filing: 13.07.2012
(51) Int. Cl.: H05K 13/02, H05K 13/08

(54) **COMPONENT MOUNTING SYSTEM**
KOMPONENTENMONTAGESYSTEM
SYSTÈME DE MONTAGE DE COMPOSANTS

(43) Date of publication of application: 20.05.2015
(73) Proprietor: FUJI Corporation, Chiryu Aichi (JP)
(72) Inventor: KAWAI, Hidetoshi, Chiryu Aichi (JP); AMANO, Masafumi, Chiryu Aichi (JP); OTA, Katsushi, Chiryu Aichi (JP); ASADA, Kazuhiro, Chiryu Aichi (JP); KUNIHIRO, Tsutomu, Chiryu Aichi (JP)
(74) Representative: Grünecker Patent- und Rechtsanwälte PartG mbB
(86) International application number: PCT/JP2012/067981
(87) International publication number: WO 2014/010084

(56) References cited:
- JP-A- H0 575 293
- JP-A- H0 575 293
- JP-A- H01 135 438
- JP-A- H01 135 438
- JP-A- H03 153 098
- JP-A- 2008 205 009
- US-A- 5 193 268

## Description

### Technical Field

The present invention relates to a component mounting system by which component supply to multiple mounter modules is performed automatically.

### Background Art

For a component mounting system comprising multiple mounter modules, a component storage cabinet which stores tape feeders housing multiple components is provided at a location separated from the mounter modules, and storage racks that store many tape feeders are provided in this component storage cabinet,

And, when components need to be supplied to a mounter module, the required tape feeder is selected from the component storage cabinet by an operator, and the tape feeder is moved by an operator to the mounter module which requires component supply and loaded to an empty feeder attachment slot of the mounter module. By doing this, even if a tape feeder runs out of components, it is possible to make it such that component supply can be continued by switching component supply to a newly loaded tape feeder, such that mounting work is not interrupted. This kind of component mounting system is disclosed in patent literature 1.

### Citation List

### Patent Literature

Patent Literature 1: Japanese Unexamined Patent Application Publication Number 2012-43886 Another component mounting system wherein tape feeders are automatically supplied and collected by a self-propelled trolley is disclosed in JPH0575293A.

### Summary of Invention

### Problem to be Solved by the Invention

However, for the electronic component mounter disclosed in patent literature 1, the work of component supply and so on must be performed by operators, and due to this production cannot be continued without stopping the production line unless one or multiple operators are always stationed at the production line, which means there is the problem that it is not possible to achieve personnel reductions or automation.

The present invention is an item which solves the above current problems whose object is a component mounting system which can perform component supply automatically by a supply unit loaded on a traveling body which can travel between a component storage cabinet and multiple mounter modules.

### Means for Solving the Problem

In order to solve the above problems, the characteristics of the invention from claim 1 are a component mounting system at which multiple mounter modules equipped with a mounting head are arranged along the conveyance direction of circuit boards, comprising: a component storage cabinet which stores multiple component supply members housing different types of components; a traveling body which can travel between the component storage cabinet and the multiple mounter modules; a moving platform provided on the traveling body which can move in a direction parallel to the traveling direction of the traveling body; a supply unit loaded on the moving platform which supports the component supply member and supplies the component supply member to the multiple mounter modules and collects the component supply member from the multiple mounter modules; wherein, multiple shared base platforms each loaded with the supply unit for which the configuration is made the same as the traveling body and the moving platform such as to be shared with respect to the multiple component supply members are provided, and on these multiple shared base platforms are each loaded a supply unit which supports either one of the at least two component supply members out of tape feeders, component trays, and bulk cassettes housing different types of components.

The invention from claim 2 is characterized such that, for the invention from claim 1, the supply unit supports multiple of the component supply members.

The invention from claim 3 is characterized such that, for the invention from claim 1 or claim 2, guide rails and number one engaging body which is parallel to the guide rails are fixed on the front surface of the multiple mounter modules; and follower rollers which engage with the guide rails, number two engaging body which engages with the number one engaging body, and a drive motor for rotating the number two engaging body are provided on the traveling body.

The invention from claim 4 is characterized such that, for the invention from claim 1 or claim 2, the traveling body is configured from an unmanned conveyance cart which can travel above the floor guided by a guide line constructed along multiple of the mounter modules.

### Effects of the Invention

According to the above configuration, at least two component supply members out of tape feeders, component trays, and bulk cassettes can be supplied to multiple mounter modules and collected from multiple mounter modules by a supply unit loaded on a traveling body which is conveyable between a component storage cabinet and multiple mounter modules, which means that the required components can be supplied automatically and efficiently, and personnel reduction and automation are possible.

Also, because at least two component supply members out of tape feeders, component trays, and bulk cassettes are loaded on a shared base platform, it is possible to perform supply of component supply members with few shared base platforms.

### Brief Description of Drawings

[FIG. 1]
   This is a conceptual top view showing the overall component mounting system of the embodiment number one of the present invention.
[FIG. 2]
   This is a conceptual top view showing a mounter module.
[FIG. 3]
   This is a perspective view of the mounter module showing an example of a feeder supply unit which makes up the supply device.
[FIG. 4]
   This is a perspective view of the mounter module showing an example of a tray supply unit which makes up the supply device.
[FIG. 5]
   This is a diagram showing the moving device which moves the moving platform.
[FIG. 6]
   This is a diagram showing the positioning means for deciding the position of the unmanned conveyance cart.
[FIG. 7]
   This is a diagram showing the indexing mechanism of the feeder supply unit.
[FIG. 8]
   This is a diagram showing the barcode reader for reading the barcodes of tape feeders or trays.
[FIG. 9]
   This is a diagram showing the contactless transmission device.
[FIG. 10]
   This is a block diagram of the control device which controls the mounter modules.
[FIG. 11]
   This is a diagram showing the relationship between the supply device and the mounter module of the number two embodiment of the present invention.
[FIG. 12]
   This is a diagram showing the relationship between the supply device and the mounter module of the number three embodiment of the present invention.
[FIG. 13]
   This is a perspective view showing an example of supplying the bulk cassette of a bulk feeder related to number four embodiment of the present invention.
[FIG. 14]
   This is a perspective view showing the cassette exchange unit of the number two embodiment.

### Description of Embodiments

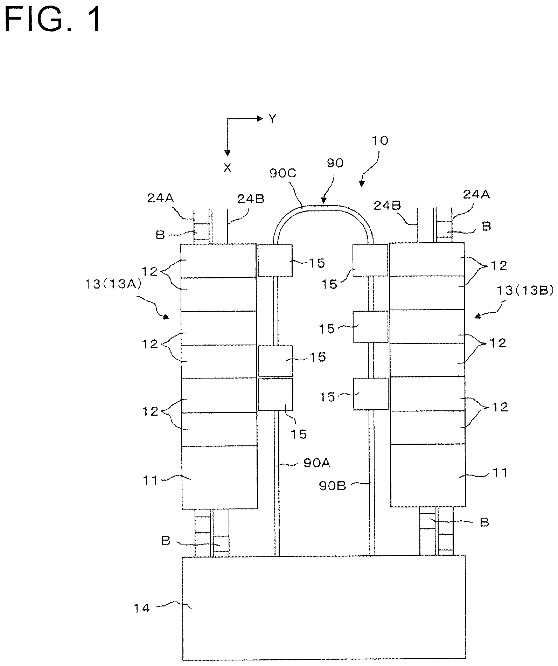

The following describes embodiments of the present invention based on the figures. FIG. 1 shows component mounting system 10 of embodiment number one of the present invention, in which the component mounting system 10 comprises work modules 13 consisting of printer module 11 for printing solder onto circuit board B and multiple mounter modules 12 which mount electronic components (hereafter referred to simply as components) onto circuit board B, component storage cabinet 14 for storing many different types of components, and multiple supply devices 15 for supplying components and collecting components between these work modules 13 and component storage cabinet 14.

Printer module 11 and multiple mounter modules 12 which make up work modules 13 are arranged along the conveyance direction (X-axis direction) of circuit board B, and these work modules 13 are provided in two rows facing each other spaced apart at a fixed distance in the Y-axis direction which is perpendicular to the X-axis direction. Multiple supply devices 15 are provided respectively such that they can travel along the two rows of work modules 13 (hereafter referred to as number one work module 13A and number two work module 13B).

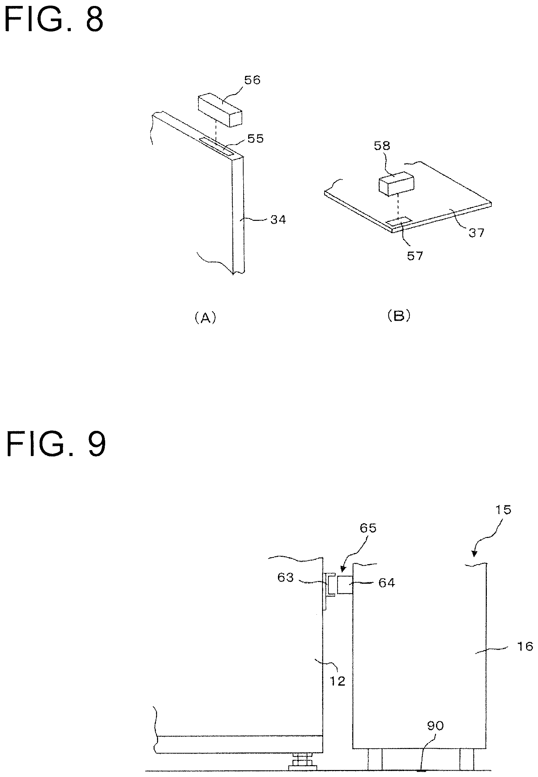

Component storage cabinet 14 is provided in a position separated in the X-axis direction with respect to number one and number two work modules 13Aand 13B. Multiple tape feeders 34 (refer to FIG. 8 [A]) housing different types of components or multiple component trays 37 (refer to FIG. 8 [B]) housing different types of components are stored in component storage cabinet 14 arranged in storage racks which are omitted from the figures, and tape feeders 34 or component trays 37 housing the required components are supplied to supply device 15 by an operator.

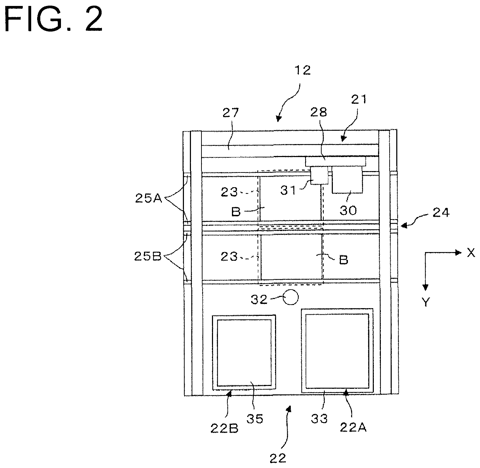

Multiple mounter modules 12, as shown in FIG. 2, are equipped with component mounter device 21, component supply device 22, board holding device 23 and board conveyance device 24.

Board conveyance device 24 has two rows of conveyor belts 25A and 25B for conveying circuit boards B in the X-axis direction, and is an item for conveying circuit boards B along these conveyor belts 25A and 25B and loading and unloading circuit boards B onto and from board holding device 23. Board holding device 23 is equipped with a board supporting device for supporting from below circuit board B which has been loaded by board conveyance device 24, and a clamping device for clamping circuit board B in position.

Component mounter device 21 is equipped with Y-axis slide 27 supported movably in the Y-axis direction in a position above board holding device 23, X-axis slide 28 which is supported movably in the X-axis direction on Y-axis slide 27, and mounting head 30 which is attached on X-axis slide 28. Although not shown in the figure, a suction nozzle for picking up and holding components is provided on mounting head 30. Y-axis slide 27 and X-axis slide 28 are respectively moved by an X-axis direction moving device and Y-axis direction moving device which use a servo motor with encoder as the drive source, such that mounting head 30 can be moved to any position in the XY plane.

Board imaging device 31 consisting of a CCD camera is provided on X-axis slide 28 and board imaging device 31 captures images of board position reference marks and board ID marks provided on circuit board B which has been positioned on board holding device 23, and acquires board position reference information and board ID information. Then, position correction is performed for mounting head 30 in the XY direction with respect to circuit board B based on the board position reference information acquired by board imaging device 31, and component mounting work is controlled based on the board ID information acquired by board imaging device 31.

32 is a component imaging device made up from a CCD camera, and component imaging device 32 captures an image of a component held on a suction nozzle of mounting head 30 during movement from component supply device 22 to above circuit board B. Then, items such as the pickup condition of the component being held on the suction nozzle and the center deviation of the component with respect to the center of the suction nozzle are detected, and items such as the movement amount in the XY direction of mounting head 30 are corrected based on items such as the center deviation, such that mounting can be performed with the component at a specified orientation and at specified coordinates on circuit board B.

Component supply device 22, as an example, is made up from feeder type component supply device 22A and tray type component supply device 22B, and feeder type component supply device 22A is equipped with multiple tape feeders 34 functioning as component supply members which are removably attached to feeder support platform 33, and these multiple tape feeders 34 are lined up in the X-axis direction. Tape housing many regularly spaced components is wound on tape feeder 34, and by intermittently indexing the tape using a sprocket moved by a motor not shown in the figures which is inside tape feeder 34, it is possible to consecutively supply components to a specified component supply position.

Further, tape feeders 34 are such that they can be removably attached to slots provided in feeder support platform 33, and when a tape feeder 34 is attached to feeder support platform 33, a connector which is omitted from the figure is connected, and electricity is supplied to tape feeder 34 from feeder support platform 33, and management information such as the ID of tape feeder 34 and control signals (component request signal, component supply complete signal and so on) which are required are transmitted between the control section of tape feeder 34 and the control section of feeder support platform 33.

On the other hand, tray type component supply device 22B is equipped with housing 35 which houses a stocker which is omitted from the figure which can be raised/lowered. Provided in the stocker are multiple tray storage racks on which are established in parallel in the vertical direction multiple component trays 37 acting as component supply members in which are housed many components, and component trays 37 stored in these tray stowage racks are able to be pulled out from the stocker in the Y-axis direction and positioned at a component supply position.

The above feeder type component supply device 22A and tray type component supply device 22B are both known items, and for feeder type component supply device 22A, for example, the technology disclosed in Japanese Unexamined Patent Application Publication No. 2012-104635 applied for by the same applicant as this invention can be used, and for tray type component supply device 22B, the technology disclosed in Japanese Unexamined Patent Application Publication No. 2009-147197 applied for by the same applicant as this invention can be used.

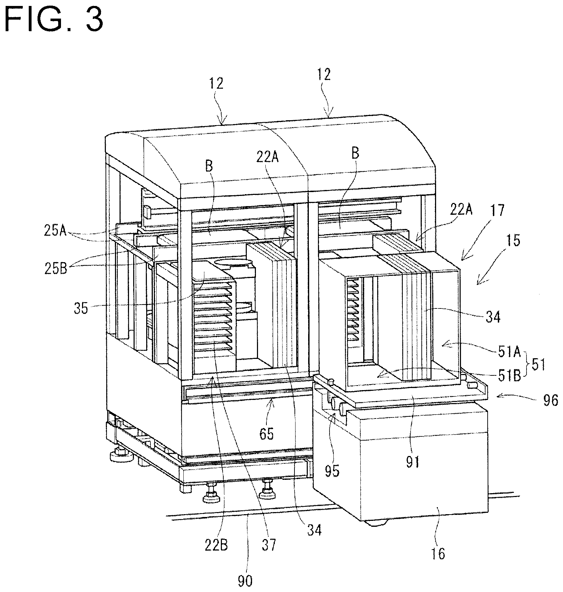

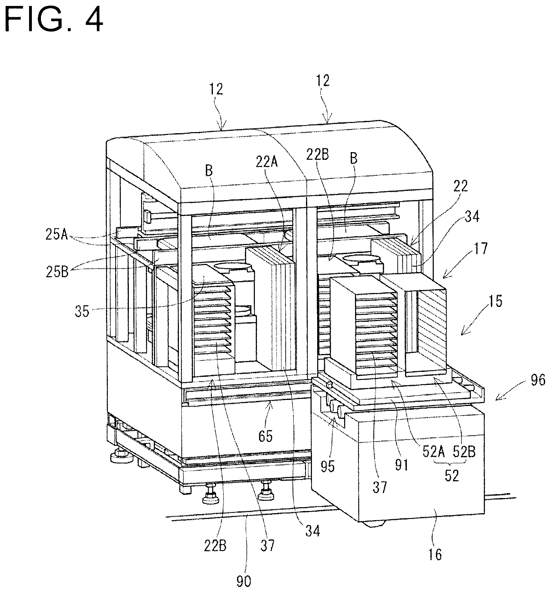

Supply device 15, as shown in FIG. 3 and FIG. 4, has unmanned conveyance cart 16 as a traveling body which can travel along each work module 13A and 13B, and supply unit 17 loaded on unmanned conveyance cart 16. Supply device 15 is an item for conveying component supply members 34 and 37 which should be supplied to mounter modules 12 and component supply members 34 and 37 which should be collected from mounter modules 12, and multiple are respectively provided for each work module 13A and 13B.

Unmanned conveyance carts 16 are provided on the floor in front of each work module 13 such that they can travel in the X-axis direction, and these multiple unmanned conveyance carts 16 are conveyed between component storage cabinet 14 and work modules 13 by the magnetic induction effect of guideline 90 set on the floor along work modules 13A and 13B.

Guideline 90, as shown in FIG. 1, is configured endlessly from guideline 90A set along the front of number one work module 13A, guideline 90B set along the front of number two work module 13B, and guideline C which connects the ends of these guidelines 90A and 90B to each other. By this, supply device 15 removed from component storage cabinet 14 can be returned to component storage cabinet 14 via number one work module 13A and number two work module 13B.

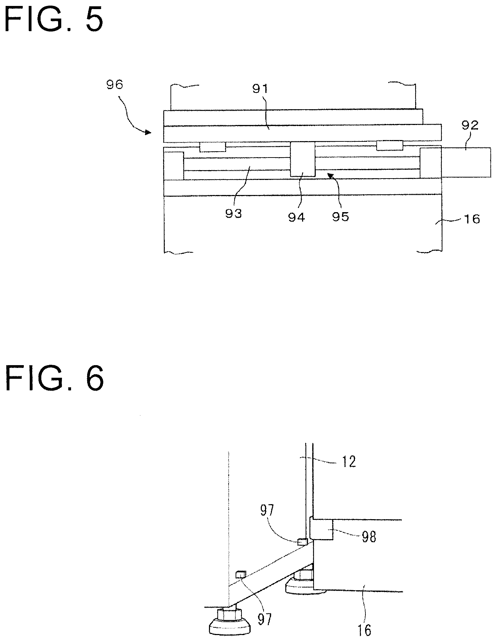

On the multiple unmanned conveyance carts 16, moving platforms 91 which support a feeder supply unit mentioned below are each guidably supported by a guide mechanism omitted from the figure such that they can each be moved in the X-axis direction. Moving platform 91, as shown in FIG. 5, is such that it can be moved in the X-axis direction by moving device 95 which is made up from ball screw 93 which is moved by motor 92 and indexing nut 94 which engages with that ball screw 93.

These multiple unmanned conveyance carts 16 and moving platforms 91 have the same configuration such that they are shared for multiple component supply members and are configured from multiple shared base platforms 96. Also, on these multiple shared base platforms 96, tape feeders 34, or feeder supply unit 51 which supports component trays 37, or tray supply unit 52 are respectively loaded.

Also, in order to accurately position unmanned conveyance cart 16 with respect to mounter module 12, as shown in FIG. 6, a pair of positioning pins 97 which comprise a positioning means are provided on the front of mounter module 12 separated in the X-axis direction such that they can be advanced/retracted, and when unmanned conveyance cart 16 is stopped at a position corresponding to mounter module 12, the pair of positioning pins 97 are advanced and the stopping position of unmanned conveyance cart 16 is corrected. By this, it is possible to accurately position unmanned conveyance cart 16 with respect to mounter module 12.

in this case, it is good to provide guide roller 98 which can contact the front of mounter module 12 on unmanned conveyance cart 16, and by running unmanned conveyance cart 16 while guide roller 98 is constantly contacting the front of mounter module 12, it is possible to maintain a fixed gap between mounter module 12 and unmanned conveyance cart 16.

Although not shown, a motor which acts as the traveling drive source is loaded on unmanned conveyance cart 16, and electric power is supplied to this motor from the work modules 13A/13B side by contactless transmission device 65 mentioned below and as such the conveyance of unmanned conveyance cart 16 is controlled. In this case, it is also acceptable to embed a battery to be used as the motor power source in unmanned conveyance cart 16, to control conveyance of unmanned conveyance cart 16 by this battery, and to charge the battery using electric power transmitted in a contactless manner by contactless transmission device 65 while components are being supplied at each mounter module 12.

Supply unit 17 loaded on unmanned conveyance cart 16 of supply device 15, as shown in FIG. 3 and FIG. 4, comes in two types, feeder supply unit 51 for holding tape feeders 34 and tray supply unit 52 for holding component trays 37, and on the multiple unmanned conveyance carts 16 one of either feeder supply unit 51 or tray supply unit 52 are loaded.

With feeder supply unit 51, feeder supply section 51A which is capable of housing multiple tape feeders 34 and which supplies these tape feeders 34 to feeder support platform 33 of mounter module 12, and feeder collection section 51B which is capable of housing multiple tape feeders 34 and which collects tape feeders 34 from feeder support platform 33 of mounter module 12, are lined up in the traveling direction of unmanned conveyance cart 16.

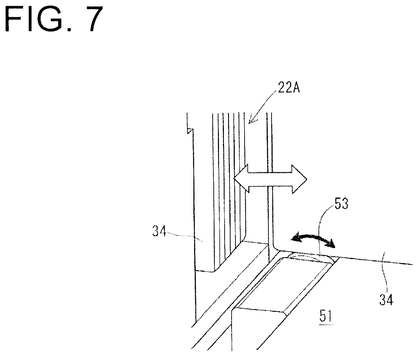

Feeder supply section 51A supports multiple tape feeders 34 lined up in the X-axis direction, and these tape feeders 34 are supported such that they can be moved in the Y-axis direction. Feeder supply section 51A, as shown in FIG. 7, is provided with a feeder indexing mechanism which includes indexing roller 53 which contacts the bottom surface of each tape feeder 34, and tape feeders 34 are indexed out from feeder supply section 51A in the Y-axis direction by the rotation of indexing roller 53 such that they can be loaded onto an empty slot of the feeder type component supply device 22A of mounter module 12.

in the same way, the same type of feeder indexing mechanism as above is provided in feeder collection section 51B too, and tape feeders 34 which should be collected from feeder type component supply device 22A of mounter module 12 are pulled out by this indexing mechanism such that they can be collected in feeder collection section 51B.

in this case, although not shown in the figure, a locking mechanism for locking and unlocking tape feeders 34 is provided on feeder support platform 33 of feeder type component supply device 22A, and, by the locking operation of this locking mechanism, tape feeder 34 is taken onto feeder support platform 33 and locked and also connected by connector. Conversely, by the unlocking operation of this locking mechanism, tape feeder 34 is unlocked and pushed out from feeder support platform 33, and the connection between tape feeder 34 and feeder support platform 33 is released.

As shown in FIG. 8 (A), barcode reader 56 for reading barcode 55 attached to tape feeder 34 housed in feeder supply section 51A is equipped on feeder supply section 51A, such that it can be checked whether the tape feeder 34 housing the required components has been supplied from component storage cabinet 14 without any mistakes. In this case, it is acceptable to provide tape feeder 34 with a 2D code or RFID instead of barcode 55 and to perform recognition of the 2D code or RFID with a camera or RFID reader provided on feeder supply section 51A.

Conversely, with tray supply unit 52, tray supply section 52A which is capable of housing multiple component trays 37 and which supplies these component trays 37 to the stocker inside housing 35 of mounter module 12, and tray collection section 52B which is capable of housing multiple component trays 37 and which collects component trays 37 from the stocker inside housing 35 of mounter module 12, are lined up in the traveling direction of unmanned conveyance cart 16.

Component trays 37 housed in tray supply section 52A are indexed out in the Y-axis direction by a tray indexing mechanism not shown in the figures such that they are supplied to a specified stowage rack of the stocker of tray type component supply device 22B of mounter module 12. In the same way, in tray collection section 52B, component trays 37 which have become empty are able to be indexed out from the stocker of tray type component supply device 22B of mounter module 12 in the Y-axis direction and collected by the tray indexing mechanism which is omitted from the figures.

Here, by making tray supply section 52A which houses multiple component trays 37 able to be moved up and down, or by using the up and down operation of the stocker of tray type component supply device 22B, multiple component trays 37 housed in each level of tray supply section 52A can be supplied to a specified stowage rack of the stocker.

As shown in FIG. 8 (B), barcode reader 58 for reading barcode 57 attached to component tray 37 housed in tray supply section 52A is equipped on tray supply section 52A, such that it can be checked whether the component tray 37 housing the required components has been supplied from component storage cabinet 14 without any mistakes.

As shown in FIG. 9, in order to perform supply of electricity and communication in a contactless manner, provided between each work module 13A/13B and supply device 15 are: belt-shaped unit 63 for contactless transmission extending in the X-axis direction on the printer module 11 and multiple mounter module 12 side; and head 64 for contactless transmission which faces unit 63 for contactless transmission on the supply device 15 side. Contactless transmission device 65 is configured from these unit 63 for contactless transmission and head 64 for contactless transmission such that electricity can be supplied from the work module 13A/13B side to the supply device 15 side, and the required communication can be performed between the work module 13A/13B side and supply device 15 side, by contactless transmission device 65.

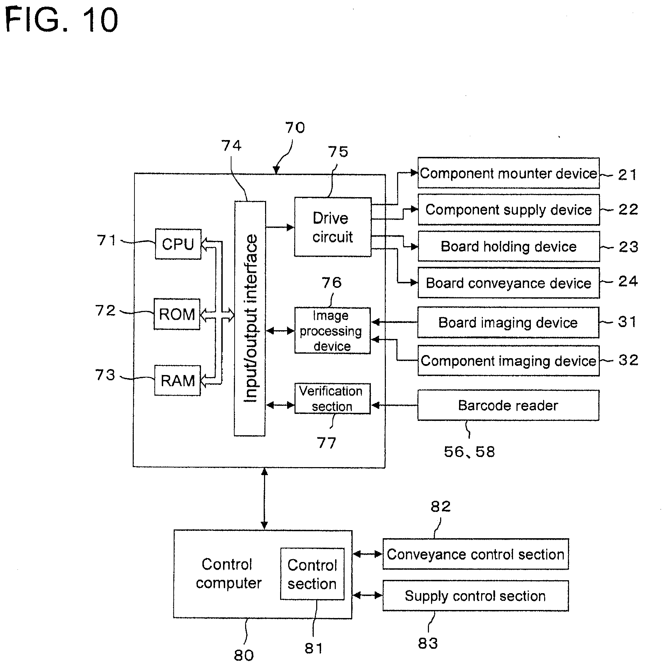

FIG. 10 shows control device 70 which controls each mounter module 12, and control device 70 is equipped with CPU 71, ROM 72, and RAM 73 and input/output interface 74 which is connected to these. Connected to input/output interface 74 are items such as component mounter device 21, component supply device 22, drive circuit 75 for driving board holding device 23 and board conveyance device 24, image processing device 76 for image processing image data captured by board imaging device 31 and component imaging device 32, and verification section 77 for verifying information read at barcode readers 56 and 58.

Saved on ROM 72 of control device 70 are data such as component model number, dimensions, and quantity of housed components for each serial ID of components housed in tape feeders 34 and component trays 37. By this, it is possible to recognize items such as the component model number when the serial ID of a component is acquired by barcode reader 56 or 58.

Control computer 80 for performing centralized control of work modules 13A and 13B and component storage cabinet 14 is connected to control device 70. Control computer 80 is equipped with control section 81 for performing centralized control of number one and number two work modules 13A and 13B, and conveyance control section 82 for controlling conveyance of supply devices 15 and supply control section 83 for controlling supply of supply devices 15 are connected to this control section 81.

Next, component supply operation in the above embodiment number one is described. Circuit boards B are conveyed consecutively in printer module 11 and mounter module 12 by board conveyance device 24, solder is printed onto conveyed circuit board B in printer module 11, and components are mounted onto circuit board B according to a predefined program by component mounter device 21 in each mounter module 12.

The remaining quantity of components is managed as each component is removed from tape feeder 34 or component tray 37 in each mounter module 12, and when components have nearly run out in a certain tape feeder 34 or component tray 37, a component supply request is issued to control computer 80 from control device 70 of mounter module 12.

Based on this issued component supply request, an instruction is issued to the operator in component storage cabinet 14 that supply should be performed of a tape feeder 34 or component tray 37 which houses the component type which is required for component supply, to feeder supply unit 51 or tray supply unit 52 of supply device 15 which is waiting in component storage cabinet 14.

For example, if a tape feeder 34 housing type A components runs out of components at a certain mounter module 12, a tape feeder 34 housing type A components is set in feeder supply section 51A of feeder supply unit 51.

in this case, when the specified tape feeder 34 is set in feeder supply section 51A, barcode 55 of the tape feeder 34 is read by barcode reader 56, and the serial ID of the tape feeder 34 is transmitted to control computer 80 connected to component storage cabinet 14. Because component related data for each serial ID is saved in control computer 80, whether the tape feeder 34 set in feeder supply section 51A is of the same type as the supply component instructed by control device 70 of mounter module 12 is verified by verification section 77. Supposing that the supply component set in feeder supply section 51A is incorrect, a verification error is reported to the operator in component storage cabinet 14.

When a tape feeder 34 housing type A components which should be supplied is set in feeder supply unit 51, unmanned conveyance cart 16 is removed from component storage cabinet 14 towards the mounter module 12 which requires component supply by the electromagnetic induction of guideline 90 (90A, 90B).

Here, information is transmitted between supply device 15 and mounter module 12 in a contactless manner by contactless transmission device 65, and the movement of supply device 15 is controlled to the mounter module 12 which requires component supply.

When supply device 15 (unmanned conveyance cart 16) has been moved to the specified mounter module 12, unmanned conveyance cart 16 is stopped at a predetermined position based on the detection signal of a sensor and so on omitted from the figure. When unmanned conveyance cart 16 is stopped, the pair of positioning pins 97 are advanced and the X-axis direction position of unmanned conveyance cart 16 is corrected and supply device 15 is accurately stopped in a position with respect to mounter module 12. In that state, moving platform 91 is moved in the X-axis direction by moving device 95 and the tape feeder 34 housing the supply components is positioned at a specified position in the X-axis direction. In that state, indexing roller 53 of the feeder indexing mechanism of feeder supply section 51A is driven in the forward direction such that tape feeder 34 is indexed towards an empty slot of feeder support platform 33 of feeder type component supply device 22A from feeder supply section 51A.

When tape feeder 34 is indexed to a predetermined position of an empty slot, the tape feeder 34 is attached to feeder support platform 33 and the connectors of tape feeder 34 and feeder support platform 33 are connected by a locking device which is omitted from the figures.

When tape feeder 34 housing supply components is attached to feeder support platform 33, next, moving platform 91 is moved a specified amount in the X-axis direction by moving device 95. By this, feeder collection section 51B of feeder supply unit 51 is positioned at the position which corresponds to the tape feeder 34 which has run out of components. In this state, the tape feeder 34 is unlocked from feeder support platform 33 by the unlocking of the locking device which is omitted from the figures, then, the indexing roller (53) of the feeder indexing mechanism of feeder supply unit 51 is reversed such that the tape feeder 34 is collected into feeder collection section 51B of feeder supply unit 51 from a slot on feeder support platform 33.

In this case, it is acceptable for, first, the tape feeder 34 which has run out of components to be collected in feeder collection section 51B of feeder supply unit 51, and then, a tape feeder 34 which should be supplied to be supplied in that empty slot.

In this way, by automatically supplying type A components which have run out to mounter module 12 from component storage cabinet 14, just by switching the component supply position to the supply position of a tape feeder 34 which has been newly attached, it is possible to continue production without interrupting mounting work, and personnel reduction and automation are possible.

Supply device 15 for which the supply and collection of tape feeders 34 are complete is returned to component storage cabinet 14 via number one work module 13A and number two work module 13B. And, in component storage cabinet 14, empty tape feeders 34 are removed from feeder collection section 51B of feeder supply unit 51 on unmanned conveyance cart 16.

In this case, if component supply is necessary at multiple mounter modules 12 at just about the same time, multiple tape feeders 34 housing the types of components required at multiple mounter modules 12 are loaded in feeder supply section 51A of feeder supply unit 51 of supply unit 17, such that it is also possible to perform supply and collection of tape feeders 34 as above while consecutively stopping unmanned conveyance cart 16 at multiple mounter modules 12.

Further, when supplying component trays 37 to mounter modules 12 also, this can be performed in the same manner as supply operation for tape feeders 34. In other words, if an instruction is issued from control device 70 of mounter module 12 to control computer 80 for supply of type B component housed in a certain component tray 37, a component tray 37 housing type B components is set in tray supply section 52A of tray supply unit 52 on an unmanned conveyance cart 16 which is waiting inside component storage cabinet 14, and conveyed to the mounter module 12 which requires component supply.

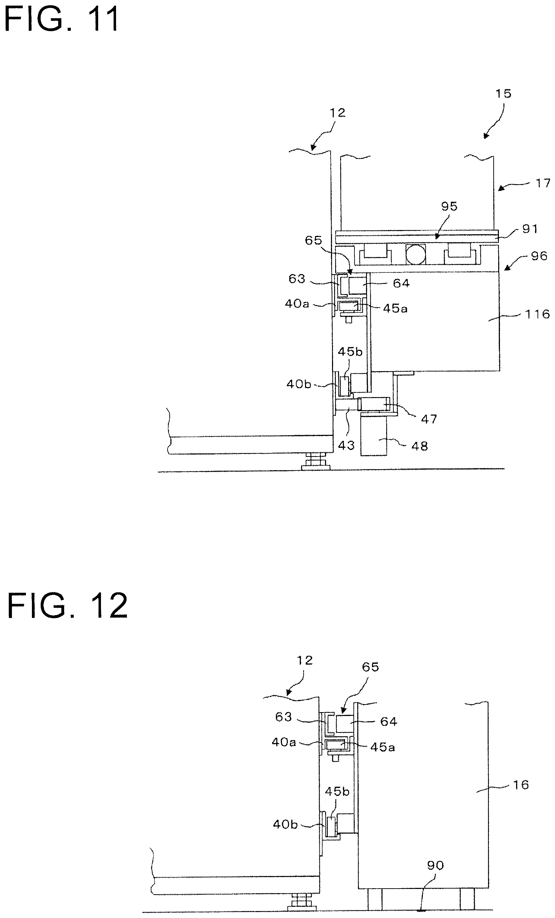

FIG. 11 shows embodiment number two of the present invention and differences from embodiment number one are that unmanned conveyance cart 16 which forms the traveling body is traveling platform 116 which travels along guide rails. For the number two embodiment, moving platform 91 is supported movably in the X-axis direction on traveling platform 116 and shared base platform 96 is configured from these traveling platform 116 and moving platform 91. Note that, for the constituent components which are the same as those mentioned for embodiment number one, the same reference symbols are used and descriptions are omitted.

In other words, for the number two embodiment, as shown in FIG. 11, on the front surface of each printer module 11 and multiple mounter modules 12 which make up number one and number two work modules 13A, upper section and lower section guide rails 40a and 40b formed with a U-shape cross section are attached along the conveyance direction (X-axis direction) of circuit board B. By this, when printer module 11 and multiple mounter modules 12 are arranged at a fixed interval along the conveyance direction of circuit board B, each upper section guide rail 40a and each lower section guide rail 40b attached to an adjacent printer module 11 and mounter module 12 are connected to each other with a slight gap, with guide rails formed in a straight line connected in the conveyance direction of circuit board B. Further, guide rails connected to the above guide rails 40a and 40b are also set in the floor in each space between each work module 13A and 13B and component storage cabinet 14.

Also, rack 43 acting as number one engaging body is attached to the front surface of printer module 11 and each mounter module 12 parallel to guide rails 40a and 40b. Rack 43 extends inside component storage cabinet 14.

Upper section follower rollers 45a which rollably engage with the side surfaces of upper section guide rail 40a, and lower section follower rollers 45b which rollably engage with the bottom surface of lower section guide rail 40b are each rotatably supported on each traveling platform 116 of supply device 15. Multiple of these upper section and lower section follower rollers 45a and 45b are provided at intervals in the traveling direction of traveling platform 116.

Also, pinions 47 acting as the number two engaging body which engage with rack 43 are each rotatably supported on each traveling platform 116, and motor 48 for rotating pinion 47 is fixed to traveling platform 116. Rotation is controlled and electrical power is supplied to motor 48 from the work modules 13A/13B side by contactless transmission device 65. Here, it is acceptable to use a chain instead of a rack as number one engaging body 43 and a sprocket wheel instead of pinion 47 as number two engaging body 47.

By this, when pinion 47 which engages rack 43 is rotated by motor 48, traveling platform 116 is conveyed between component storage cabinet 14 and each work module 13 guided by guide rails 40a and 40b. In other words, motor 48 functions as the drive motor for making traveling platform 116 move.

For the number two embodiment, supply device 15 is conveyed by traveling platform 116 which travels by the rotation of drive motor 48 to a position corresponding to a mounter module 12 which requires component supply, and is positioned at a predetermined position. By this, traveling platform 116 can be positioned at a specified position with respect to mounter module 12 by the stopping accuracy of drive motor 48, and the positioning means (positioning pins 97) mentioned in the number one embodiment above can be made unnecessary.

FIG. 12 shows embodiment number three of the present invention, which while using unmanned conveyance cart 16, is an item which guides unmanned conveyance cart 16 by upper section and lower section guide rails 40a and 40b mentioned in embodiment two. According to this, the positional accuracy in the Y-axis direction of unmanned conveyance cart 16 which is positioned at each mounter module 12 can be improved.

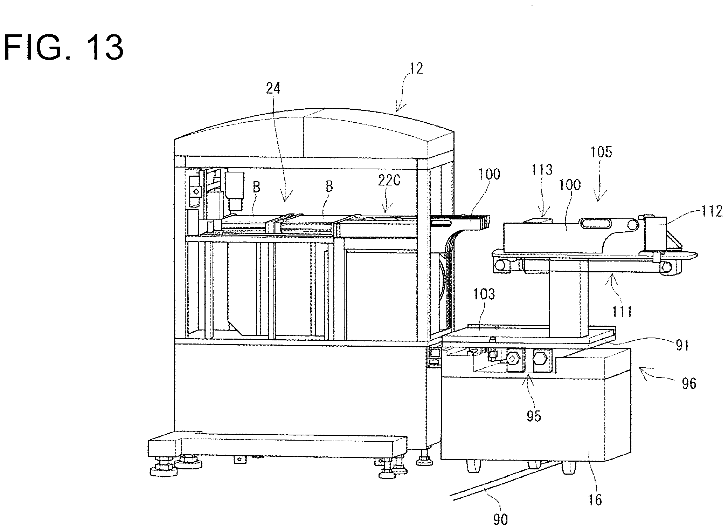

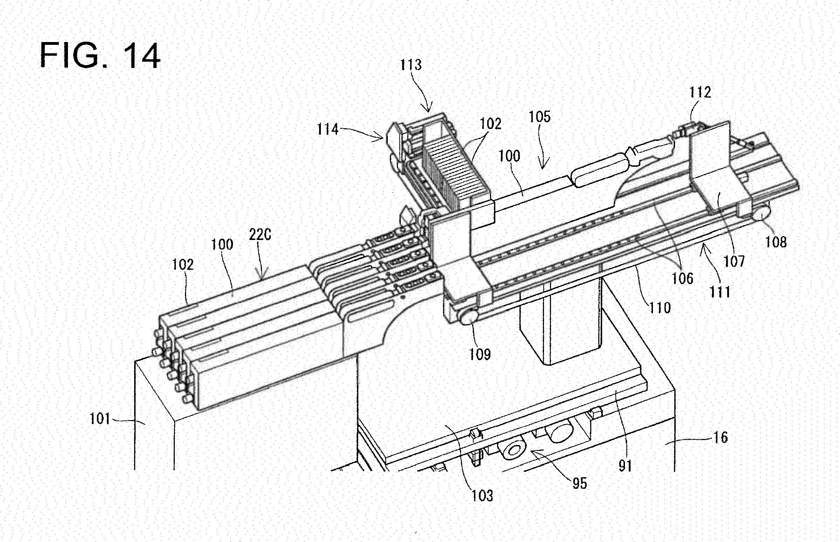

FIG. 13 and FIG. 14 show embodiment number four of the present invention, and show an applicable example in which a mounter module 12 equipped with component supply device 22C made from bulk feeder 100 is set on at least one work module 13, in which bulk cassettes functioning as component supply members can be supplied to bulk feeder 100 by supply device 15 on the mounter module 12.

in FIG. 13 and FIG. 14, component supply device 22C made from multiple bulk feeders 100 arranged in a row in the X-axis direction is provided on mounter module 12. The multiple bulk feeders 100 are attached to feeder support platform 101 such that they can be attached/removed in the Y-axis direction. Bulk cassette 102 which houses many components in bulk form is attachably/removably provided on bulk feeder 100, and components housed in bulk cassette 102 are supplied to a component supply position by an appropriate means such that they can be picked up by a suction nozzle.

Support platform 103 is provided on moving platform 91 (shared base platform 96) of supply device 15 which supplies bulk cassette 102 of bulk feeder 100 automatically, and cassette exchange unit 105 is provided on this support platform 103. Cassette exchange unit 105 has slider 107 which is capable of being slid in the Y-axis direction along a pair of guide rails 106, and slider 107 is moved in the Y-axis direction by belt transmission mechanism 111 made from a pair of pulleys 108 and 109, and endless belt 110.

Engaging section 112 which can disengageably engage with the tip section of bulk feeder 100 is provided on slider 107, and by engaging engaging section 112 with the bulk feeder 100 which should be exchanged, a bulk feeder 100 in mounter module 12 is drawn onto cassette exchange unit 105.

Cassette exchange unit 105 is equipped with cassette storage magazine 113 in which multiple bulk cassettes 102 are stored lined up in the X-axis direction. Also, cassette exchange unit 105 is equipped with cassette exchanging hand 114 which exchanges bulk cassettes 102 between bulk feeder 100 which was drawn onto cassette exchange unit 105 and cassette storage magazine 113.

Cassette exchanging hand 114 grips the bulk cassette 102 inside bulk feeder 100 which should be collected, removes it from bulk feeder 100, and returns it to an empty space in cassette storage magazine 113. After that, bulk cassette 102 which should be supplied is gripped by cassette exchanging hand 114, removed from cassette storage magazine 113, and set on bulk feeder 100.

It is possible to check whether the bulk cassette 102 which needed to be supplied was attached to bulk feeder 100 without a mistake by providing a 2D code or RFID on bulk cassettes 102 and loading a camera or RFID reader on cassette exchanging hand 114. Further, when the type of bulk cassette 102 is changed, it is possible to provide support by exchanging the hand section of cassette exchanging hand 114.

With this embodiment, changeover can be automatic for even high-mix low-volume production by conveying supply device 15 housing many types of bulk cassettes 102 in cassette storage magazine 113 to each mounter module 12.

According to the above embodiment, provided are: component storage cabinet 14 which stores multiple component supply members 34 and 37 with different types of components; traveling bodies 16 and 116 which can travel between component storage cabinet 14 and multiple mounter modules 12; moving platform 91 provided on traveling bodies 16 and 116 which can move in a direction parallel to the traveling direction of traveling bodies 16 and 116; and supply unit 17 loaded on moving platform 91 which supports component supply members 34 and 37 and which supplies component supply members 34 and 37 to multiple mounter modules 12 and collects component supply members 34 and 37 from multiple mounter modules 12. Also, multiple shared base platforms 96 each loaded with the supply unit 17 for which the configuration is made the same as traveling bodies 16 and 116 and moving platform 91 such as to be shared with respect to multiple component supply members 34 and 37; and on these multiple shared base platforms 96 are each loaded supply unit 17 which supports either one of the at least two component supply members out of tape feeders 34, component trays 37, and bulk cassettes 102 housing different types of components.

According to the above configuration, even if components run out in mounter module 12, the required components can be supplied automatically and efficiently by traveling body 16 or 116 which supports component supply member 34, 37, or 102 which has run out components traveling from component storage cabinet 14 to mounter module 12, and personnel reduction and automation are possible.

By this, it is fine if operators just supply the required component supply members 34, 37 and 102 to supply unit 17 inside component storage cabinet 14, and by automating the supply of component supply members 34, 37, and 102 to supply device 15 at component storage cabinet 14, it is possible to continuously operate the component mounting system without operators.

Also, because tape feeders 34, component trays 37, and bulk cassettes 102 are loaded on shared base platform 96, it is possible to perform supply of tape feeders 34, component trays 37, and bulk cassettes 102 with few shared base platforms 96.

According to the above embodiments, because supply unit 17 can support multiple component supply members 34, 37 and 102, it is possible to supply multiple component supply members 34 and 37 to mounter module 12 by conveying supply unit 17 which is supporting multiple component supply members 34, 37 and 102 by traveling bodies 16 and 116.

According to the above embodiments, guide rails 40a and 40b and rack (chain) 43 parallel to guide rails 40a and 40b are each fixed on the front of multiple mounter modules 12; and follower rollers 45a and 45b which engage with guide rails 40a and 40b, pinion 47 (sprocket wheel) 47 which engages with rack 43, and drive motor 48 for rotating pinion 47 are provided on traveling bodies 16 and 116.

By this, it is possible to convey shared base platform 96 via pinion 47 and rack 43 by the rotation of drive motor 48, and further, supply unit 17 on shared base platform 96 can be accurately positioned in a position corresponding to mounter module 12 by the rotation stopping accuracy of drive motor 48.

According to the above embodiments, because the traveling body is configured from unmanned conveyance cart 16 which can travel above the floor guided by guideline 90 set along multiple mounter modules 12, it is possible to create a component mounting system which can automate component supply fairly easily by arranging unmanned conveyance cart 16 and guideline 90 without making large modifications to mounter module 12.

According to the above embodiments, multiple component supply members (tape feeders 34 or component trays 37) can be supported on supply unit 17, but it is also acceptable for a single component supply member to be supported on supply unit 17.

According to the above embodiments, an example was given in which two rows of work modules 13A and 13B were arranged with a gap in the X-axis direction, but it is also possible to have three rows or more, or a single row, of work modules.

Also, an example of guideline 90 which magnetically guides unmanned conveyance cart 16 with an endless form was given, but it is also acceptable to provide this in a straight line on the front of work modules 13A and 13B. Here, when supplying components to multiple mounter modules 12 by multiple supply devices 15 at the same time, it is desirable to remove multiple supply devices 15 from component storage cabinet 14 simultaneously, and after component supply work is complete for multiple mounter modules 12, to return multiple supply devices 15 to component storage cabinet 14 simultaneously.

Further, according to the above embodiments, an example was given in which two rows of work modules 13A and 13B were arranged with a gap in the X-axis direction, but it is also possible to have three rows or more, or a single row, of work modules.

Embodiments of the present invention were described above, but the present invention is not limited to the above embodiments, and various forms which do not extend beyond the range of the object of the present invention as given in the claims are possible.

### Industrial Applicability

The present invention of a component mounting system is appropriate for use as an item for supplying components by a supply device which can travel between a component storage cabinet and multiple mounter modules.

### Reference Number List

10: Component mounting system; 12: Mounter module; 13: Work module; 14: Component storage cabinet; 15: Supply device; 16, 116: Traveling body (unmanned conveyance cart, traveling platform); 17: Supply unit; 34: Tape feeder; 37: Tray; 40a, 40b: Guide rail; 43: Number one engaging body; 47: Number two engaging body; 48: Drive motor; 51: Feeder supply unit; 52: Tray supply unit; 65: Contactless transmission device; 70: Control device; 77: Verification section; 80 Control computer; 90: Guideline; 91: Moving platform; 95: Moving device; 96: Shared base platform; 100: Bulk feeder; 102: Bulk cassette; 105: Cassette exchange unit

## Claims

1. A component mounting system (10) at which multiple mounter modules (12) equipped with a mounting head (30) are arranged along a conveyance direction of circuit boards (B), comprising:
a component storage cabinet (14) which is configured to store multiple component supply members (34, 37, 102) of multiple types housing different types of components;
a traveling body (16, 116) which is configured to automatically travel between the component storage cabinet (14) and the multiple mounter modules (12);
a moving platform (91) provided on the traveling body (16, 116) which is configured to move in a direction parallel to the traveling direction of the traveling body (16, 116);
a supply unit (17) loaded on the moving platform (91) which is configured to hold the component supply members (34, 37) and to supply the component supply members (34, 37) to the multiple mounter modules (12) and to collect the component supply members (34, 37) from the multiple mounter modules (12);
wherein multiple shared base platforms (96) are provided, each being configured from one traveling body (16, 116) and one moving platform (91), for which the configuration is made the same, such as to be shared with respect to the multiple types of component supply members (34, 37, 102), and
on each of these multiple shared base platforms (96) is loaded a supply unit (17) which is configured to hold at least two component supply members (34, 37, 102) of one type out of tape feeders (34), component trays (37), and bulk cassettes (102) housing different types of components,
**characterized in that**
said supply unit (17) is further configured to perform supply and collection of each component supply member (34, 37, 102) while consecutively stopping the traveling body (16, 116) at multiple mounter modules (12).

2. The component mounting system (10) according to claim 1 wherein guide rails (40a, 40b) and number one engaging body (43) which is parallel to the guide rails (40a, 40b) are fixed on the front surface of the multiple mounter modules (12); and
follower rollers (45a, 45b) which are configured to engage with the guide rails (40a, 40b), number two engaging body (47) which is configured to engage with the number one engaging body (43), and a drive motor (48) for rotating the number two engaging body (47) are provided on the traveling body (116).

3. The component mounting system (10) according to claim 1 wherein the traveling body (16) is configured from an unmanned conveyance cart (16) which is configured to travel above the floor guided by a guideline (90) constructed along multiple of the mounter modules (12).

## Patentansprüche

1. Komponentenmontagesystem (10), bei welchem mehrere Montagemodule (12), die mit einem Montagekopf (30) ausgestattet sind, entlang einer Förderrichtung von Leiterplatten (B) angeordnet sind, umfassend:
einen Komponentenlagerschrank (14), der konfiguriert ist, mehrere Komponentenzuführelemente (34, 37, 102) mehrerer Typen zu lagern, die verschiedene Typen von Komponenten aufnehmen;
einen verfahrbaren Körper (16, 116), der konfiguriert ist, automatisch zwischen dem Komponentenlagerschrank (14) und den mehreren Montagemodulen (12) zu fahren;
eine bewegliche Plattform (91), die an dem verfahrbaren Körper (16, 116) bereitgestellt ist, die konfiguriert ist, sich in einer Richtung parallel zu der Fahrrichtung des verfahrbaren Körpers (16, 116) zu bewegen;
eine Zufuhreinheit (17), die auf die bewegliche Plattform (91) geladen ist, die konfiguriert ist, die Komponentenzuführelemente (34, 37) zu halten und die Komponentenzuführelemente (34, 37) den mehreren Montagemodulen (12) zuzuführen und die Komponentenzuführelemente (34, 37) von den mehreren Montagemodulen (12) zu sammeln;
wobei mehrere gemeinsame Basisplattformen (96) bereitgestellt ist, die jeweils von einem verfahrbaren Körper (16, 116) und einer beweglichen Plattform (91) konfiguriert sind, für welche dieselbe Konfiguration gemacht ist, um bezüglich der mehreren Typen von Komponentenzuführelementen (34, 37, 102) gemeinsam benutzt zu werden, und
auf jeder dieser mehreren gemeinsamen Basisplattformen (96) eine Zufuhreinheit (17) geladen ist, die konfiguriert ist, um mindestens zwei
Komponentenzuführelemente (34, 37, 102) eines Typs aus Kassettenzuführvorrichtungen (34), Komponententabletts (37) und Schüttgut-Kassetten (102), die verschiedene Typen von Komponenten aufnehmen, zu halten,
**dadurch gekennzeichnet, dass**
die Zufuhreinheit (17) ferner konfiguriert ist, um ein Zuführen und Sammeln von jedem Komponentenzuführelement (34, 37, 102) auszuführen, während der verfahrbare Körper (16, 116) an mehreren Montagemodulen (12) nacheinander angehalten wird.

2. Das Komponentenmontagesystem (10) nach Anspruch 1, wobei Führungsschienen (40a, 40b) und ein Eingriffskörper (43) Nummer Eins, welcher parallel zu den Führungsschienen (40a, 40b) ist, an der vorderen Fläche der mehreren Montagemodule (12) befestigt sind; und
Mitläuferrollen (45a, 45b), die konfiguriert sind, um mit den Führungsschienen (40a, 40b) im Eingriff zu stehen, ein Eingriffskörper (47) Nummer Zwei, der konfiguriert ist, um mit dem Eingriffskörper (43) Nummer Eins im Eingriff zu stehen, und ein Antriebsmotor (48) zum Drehen des Eingriffskörpers (47) Nummer Zwei an dem verfahrbaren Körper (116) bereitgestellt sind.

3. Das Komponentenmontagesystem (10) nach Anspruch 1, wobei der verfahrbare Körper (16) von einem unbemannten Transportkarren (16) gebildet wird, der konfiguriert ist, über dem Boden mittels einer Führungslinie (90) geführt zu fahren, die entlang von mehreren der Montagemodule (12) eingerichtet ist.

## Revendications

1. Système de montage de composants (10) au niveau duquel sont agencés de multiples modules de montage (12) munis d'une tête de montage (30) le long de la direction de transport de cartes à circuit imprimé (B), comprenant :
une armoire de stockage de composants (14) qui est configurée pour stocker de multiples éléments d'alimentation en composants (34, 37, 102) de multiples types hébergeant différents types de composants,
un corps circulant (16, 116) qui est configuré pour se déplacer automatiquement entre l'armoire de stockage de composants (14) et les multiples modules de montage (12),
une plate-forme mobile (91) disposée sur le corps circulant (16, 116), laquelle est configurée pour se déplacer dans une direction parallèle à la direction de déplacement du corps circulant (16, 116),
une unité d'alimentation (17) chargée sur la plate-forme mobile (91) qui est configurée pour supporter les éléments d'alimentation en composants (34, 37) et pour délivrer les éléments d'alimentation en composants (34, 37) aux multiples modules de montage (12) et recueillir les éléments d'alimentation en composants (34, 37) auprès des multiples modules de montage (12),
dans lequel de multiples plates-formes de base partagées (96) sont prévues, chacune étant configurée à partir d'un corps circulant (16, 116) et d'une plate-forme mobile (91), pour lesquelles la configuration est identique, de sorte à pouvoir être partagées en regard des multiples types d'éléments d'alimentation en composants (34, 37, 102), et
une unité d'alimentation (17) est chargée sur chacune de ces multiples plates-formes de base partagées (96), laquelle est configurée pour supporter au moins deux éléments d'alimentation en composants (34, 37, 102) d'un type choisis parmi des distributeurs à bande (34), des plateaux de composants (37) et des cassettes de vrac (102) accueillant différents types de composants,
**caractérisé en ce que** :
ladite unité d'alimentation (17) est en outre configurée pour effectuer la délivrance et le recueil de chaque élément d'alimentation en composants (34, 37, 102) tout en stoppant consécutivement le corps circulant (16, 116) au niveau de multiples modules de montage (12).

2. Système de montage de composants (10) selon la revendication 1, dans lequel des rails de guidage (40a, 40b) et un corps d'engrènement numéro un (43) qui est parallèle aux rails de guidage (40a, 40b) sont fixés sur la surface avant des multiples modules de montage (12), et
des galets suiveurs (45a, 45b) qui sont configurés pour s'engrener avec les rails de guidage (40a, 40b), le corps d'engrènement numéro deux (47) qui est configuré pour s'engrener avec le corps d'engrènement numéro un (43) et un moteur d'entraînement (48) destiné à mettre en rotation le corps d'engrènement numéro deux (47) sont disposés sur le corps circulant (116).

3. Système de montage de composants (10) selon la revendication 1, dans lequel le corps circulant (16) est configuré à partir d'un chariot de transport sans pilote (16) qui est configuré pour se déplacer au-dessus du sol, guidé par une ligne de guidage (90) dessinée le long de multiples modules de montage (12).
